# DEMANDE DE BREVET EUROPEEN

(11) **EP 1 005 087 A1**
(43) Date de publication de la demande: **31.05.2000**
(21) Numéro de dépôt: 99402902.3
(22) Date de dépôt: 23.11.1999
(51) Int. Cl.: H01L 23/522, H01L 21/768

(54) **Circuit intégré et procédé de fabrication associé**

(30) Priorité: 26.11.1998 FR 9814908
(71) Demandeur: STMicroelectronics SA, 94250 Gentilly Cedex (FR); FRANCE TELECOM, 75015 Paris (FR)
(72) Inventeur: Gayet, Philippe, 38660 St. Vincent de Mercuze (FR)
(74) Mandataire: Casalonga, Axel

(57) **Abrégé**

Circuit intégré comprenant des pistes d'au moins un niveau de métallisation pourvu de couches diélectriques et des vias métallisés connectant des pistes de deux niveaux voisins. Au moins une partie d'au moins un niveau de métallisation n est scindée en deux niveaux partiels décalés en hauteur.

## Description

La présente invention concerne le domaine des circuits intégrés à semi-conducteurs, comprenant un empilement de couches conductrices séparées par des couches isolantes et leur procédé de fabrication.

Dans de tels circuits intégrés, il est nécessaire d'établir des connexions électriques entre des couches métallisées conductrices de niveaux différents et par conséquent séparées par une ou plusieurs couches isolantes.

De façon connue, deux couches conductrices sont connectées électriquement au moyen de trous prévus dans la couche isolante et remplis de métal, une telle connexion étant appelée "Via".

Les circuits intégrés peuvent être réalisés de façon conventionnelle par dépôt puis gravure d'une couche métallisée, et par remplissage des espaces dégagés par la gravure par un matériau diélectrique.

Les circuits intégrés peuvent aussi être réalisés selon un procédé appelé "Damascène", dans lequel on dépose une première couche isolante sur une couche de métallisation de niveau n-1. On effectue la gravure des trous à travers cette couche isolante, on dépose le métal constituant le via et on le polit jusqu'au niveau de la surface supérieure de la couche isolante, puis on dépose une nouvelle couche isolante sur le via de niveau n ainsi constitué, on effectue la gravure des tranchées constituant les futures lignes, on dépose le métal constituant les lignes de la couche de métallisation de niveau n, puis on polit le métal jusqu'au niveau de la surface supérieure de la couche isolante, etc.

Ce procédé est bien adapté à la réalisation de lignes et de vias en cuivre, ce matériau ne pouvant être gravé à température ambiante et présentant des caractéristiques électriques intéressantes pour les lignes de faible section. Ce procédé peut aussi être utilisé avec les métaux constituant habituellement les lignes et les vias.

Dans le procédé "double damascène", le métal est déposé à la fois dans les vias et les lignes, puis poli. Dans un mode de réalisation, une couche d'arrêt, habituellement en nitrure, est prévue entre une couche isolante des vias et des lignes. L'obtention de la structure finale nécessite une excellente sélectivité de la gravure de l'oxyde constituant la couche isolante par rapport au nitrure.

Pour augmenter la densité d'un circuit intégré, on cherche à réduire la largeur des lignes de métal et la largeur du matériau diélectrique séparant deux lignes de métal. Or, la capacité électrique existant entre deux lignes de métal adjacentes est inversement proportionnelle à la distance les séparant. En réduisant cette distance pour augmenter la densité du circuit, on augmente la capacité entre lignes, ce qui est gênant car cela se traduit par une augmentation de la constante de propagation du signal électrique dans les lignes τ = RC (R : résistance de la ligne métal; C : capacité interlignes), ainsi que par une augmentation du couplage parasite entre deux signaux électriques se propageant dans deux lignes adjacentes (effet de "cross talk"). Or, cette capacité entre lignes est proportionnelle au coefficient de permittivité "k" du matériau diélectrique utilisé et à la surface latérale des lignes. On tend donc à utiliser des matériaux diélectriques à faible coefficient de permittivité "k" ou à utiliser des matériaux conducteurs moins résistifs (cuivre) pour réduire la hauteur des lignes et donc la surface latérale.

Ces nouveaux matériaux posent encore aujourd'hui des problèmes d'intégration dans le domaine de la fabrication des circuits intégrés.

La présente invention a pour objet de remédier aux inconvénients des techniques évoquées ci-dessus.

La présente invention a pour objet de proposer un circuit intégré à capacités interlignes réduites.

Le circuit intégré, selon l'invention, comprend des pistes d'au moins un niveau de métallisation pourvu de couches diélectriques et des vias métallisés connectant des pistes de deux niveaux voisins. Au moins une partie d'au moins un niveau de métallisation n est scindée en deux niveaux partiels décalés en hauteur. Le circuit comprend au moins un via connectant une piste du niveau partiel supérieur et un élément situé sous la couche diélectrique de niveau n, ledit via traversant la couche diélectrique de niveau n et le matériau diélectrique séparant les pistes du niveau partiel inférieur. Le circuit comprend au moins un via connectant une piste du niveau partiel inférieur et une piste d'un niveau de métallisation n+1, ledit via traversant la couche diélectrique de niveau n+1 et le matériau diélectrique séparant les pistes du niveau partiel supérieur, et au moins un via connectant une piste du niveau partiel inférieur et un élément situé sous la couche diélectrique de niveau n. Ce dernier via traverse la couche diélectrique de niveau n. Cela a pour effet d'augmenter la distance moyenne séparant mutuellement les pistes conductrices dans ladite partie et de diminuer les capacités interlignes qui sont inversement proportionnelles à cette distance.

Dans un mode de réalisation de l'invention, les pistes de ladite partie du niveau de métallisation sont réparties entre un niveau partiel supérieur et un niveau partiel inférieur.

Dans un mode de réalisation de l'invention, les pistes de ladite partie du niveau de métallisation sont prévues sans croisement entre elles.

Dans un mode de réalisation de l'invention, les niveaux partiels supérieur et inférieur sont adjacents.

Dans un mode de réalisation de l'invention, les niveaux partiels supérieur et inférieur sont séparés par une couche de matériau diélectrique supplémentaire.

Dans un mode de réalisation de l'invention, la couche de matériau diélectrique supplémentaire est traversée par au moins un via connectant une piste du niveau partiel supérieur et un élément situé sous la couche diélectrique de niveau n et par au moins un via connectant une piste du niveau partiel inférieur et une piste d'un niveau de métallisation n+1. Les niveaux partiels supérieur et inférieur peuvent être séparés par une couche de matériau diélectrique supplémentaire et par une couche d'arrêt.

Dans le procédé de fabrication d'un circuit intégré, selon l'invention, on dépose une deuxième couche diélectrique sur une première couche diélectrique pourvue de vias, on grave des tranchées dans la deuxième couche diélectrique, on réalise des pistes conductrices en remplissant de métal les dites tranchées, on dépose une troisième couche diélectrique, on grave des tranchées dans la troisième couche diélectrique, et on réalise des pistes conductrices en remplissant de métal les dites tranchées, pour obtenir au moins une partie du niveau de métallisation ainsi obtenu, scindée en deux niveaux partiels décalés en hauteur.

Dans un mode de réalisation, une couche d'arrêt peut être déposée avant la troisième couche diélectrique pour contrôler la profondeur des tranchées.

Dans le procédé de fabrication d'un circuit intégré, selon l'invention, on dépose une couche d'arrêt sur une première couche diélectrique, on grave des trous dans la couche d'arrêt, on dépose une deuxième couche diélectrique, on grave des tranchées dans la deuxième couche diélectrique et des trous dans la première couche diélectrique aux emplacements correspondants à ceux des trous de la couche d'arrêt, on réalise des vias et des pistes conductrices en remplissant de métal les dits trous et les dites tranchées, on dépose une troisième couche diélectrique et une deuxième couche d'arrêt, on grave des trous dans la deuxième couche d'arrêt et on dépose une quatrième couche diélectrique, on grave des tranchées dans la quatrième couche diélectrique et des trous dans la troisième couche diélectrique aux emplacements correspondants aux trous de la deuxième couche d'arrêt, et on réalise des vias et des pistes conductrices en remplissant de métal les dits trous et les dites tranchées, pour obtenir au moins une partie du niveau de métallisation ainsi obtenu, scindée en deux niveaux partiels décalés en hauteur.

Dans le procédé de fabrication d'un circuit intégré, selon l'invention, on dépose puis on grave une première couche métallisée sur une couche diélectrique pourvue de vias, on remplit de matériau diélectrique les espaces laissés libres par la gravure, on dépose puis on grave une deuxième couche métallisée, on remplit de matériau diélectrique les espaces laissés libres par la gravure, pour obtenir au moins une partie du niveau de métallisation ainsi obtenu, scindée en deux niveaux partiels décalés en hauteur.

Les masques servant à la fabrication des lignes conductrices peuvent comporter des zones évidées correspondant à des prolongements servant à connecter une ligne d'un niveau partiel donné, supérieur ou inférieur avec un via disposé à l'opposé dudit niveau partiel, respectivement sous le niveau partiel inférieur ou sur le niveau partiel supérieur.

Ainsi, on dispose d'un circuit intégré qui peut être réalisé avec des largeurs de matériau diélectrique entre lignes très faibles en raison de l'utilisation de la géométrie améliorée, conforme à l'invention et qui peut être fabriqué selon plusieurs technologies.

La présente invention sera mieux comprise à l'étude de la description détaillée de quelques modes de réalisation pris à titre d'exemples nullement limitatifs et illustrés par les dessins annexés, sur lesquels :
- la figure 1 est une vue de dessus d'un circuit intégré selon l'art antérieur ;
- les figures 2 et 3 sont des vues en coupe selon II-IIet III-III de la figure 1 ;
- la figure 4 est une vue de dessus d'un circuit intégré conforme à l'invention ;
- les figures 5 et 6 sont des vues en coupe selon V-V et VI-VI de la figure 4 ;
- les figures 7 à 10 sont des vues de dessus des masques utilisés pour la fabrication d'un circuit intégré selon l'invention ; et
- les figures 11 à 13 sont des vues en coupe de circuit intégré conforme à l'invention.

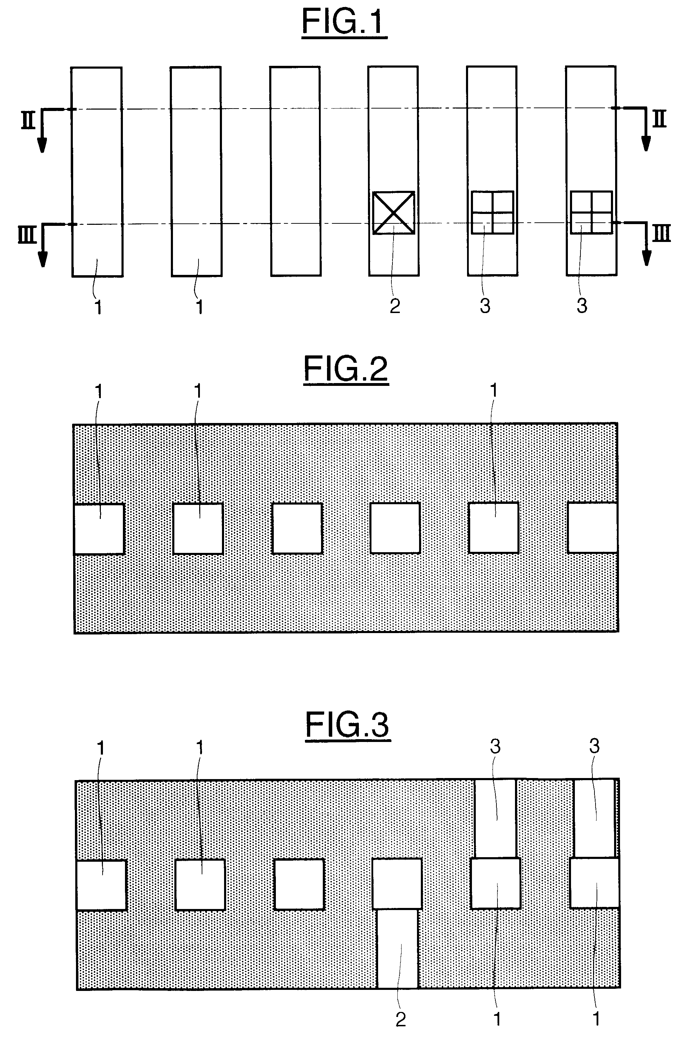

Comme on peut le voir sur les figures 1 à 3, une portion de circuit intégré comprend, à un niveau conducteur donné, une pluralité de lignes conductrices 1, par exemple métallisées, et une pluralité de vias 2, 3 permettant de relier électriquement deux lignes de couches conductrices adjacentes et superposées ou une ligne d'une couche conductrice et une portion d'un substrat semi-conducteur disposé en-dessous. Plus particulièrement sur la figure 3, on voit que le via 2 permet de connecter une ligne 1 d'une couche conductrice donnée avec un élément disposé en-dessous et que les vias 3 permettent de connecter des lignes 1 à des éléments disposés au-dessus de la couche conductrice à laquelle appartiennent les lignes 1. La capacité existant entre deux lignes 1 du même niveau conducteur est proportionnelle à la permittivité du diélectrique les séparant et à leur surface mutuellement en regard et inversement proportionnelle à la distance les séparant.

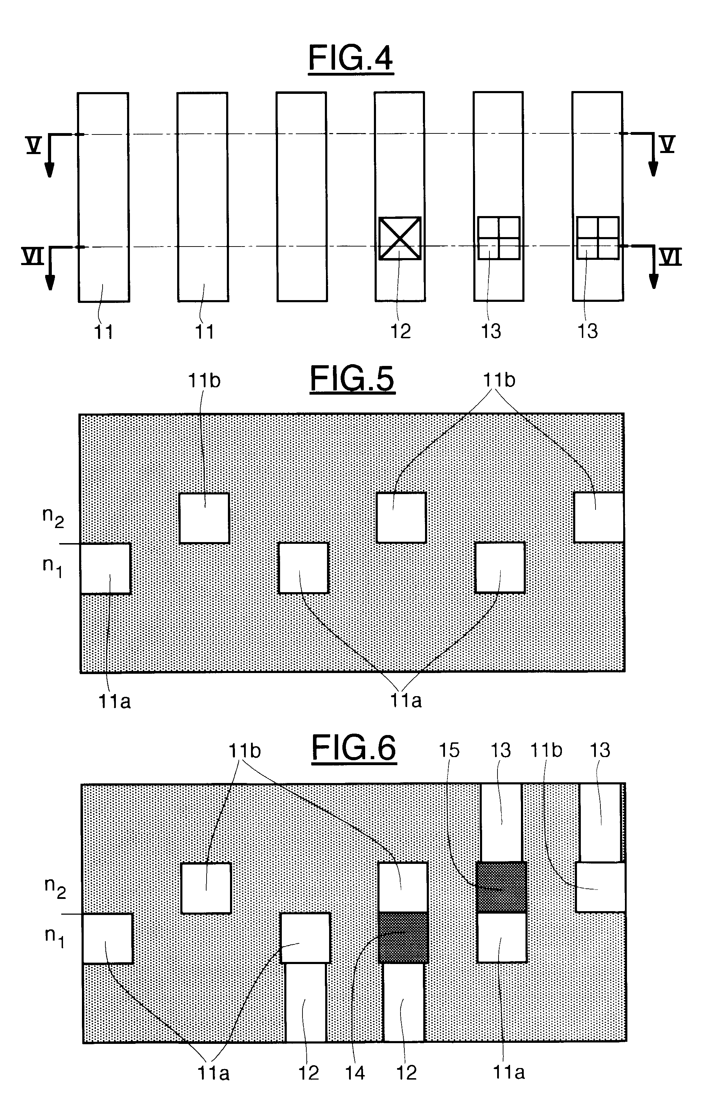

Sur les figures suivantes, les références des éléments semblables à ceux des figures précédentes ont été augmentées du nombre 10. Sur la figure 4, on voit que le circuit intégré, conforme à l'invention, comprend des lignes métallisées 11, des vias descendants 12 et des vias montants 13. Toutefois, il convient de noter que l'invention peut parfaitement s'appliquer à des circuits intégrés pourvus d'un unique niveau conducteur et dans lequel les vias sont uniquement des vias descendants vers le substrat semi-conducteur.

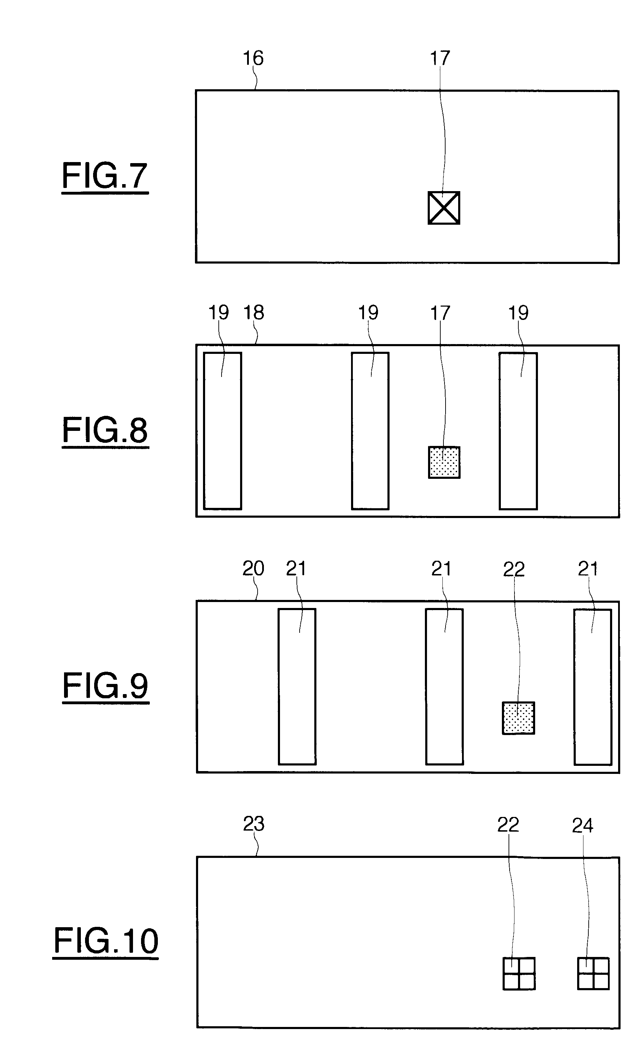

Sur la figure 5, on voit que certaines des lignes conductrices du niveau conducteur représenté ont été décalées dans le sens de la hauteur. Ainsi, les lignes 11a sont disposées à un niveau partiel inférieur tandis que les lignes 11b sont disposées à un niveau partiel supérieur, l'ensemble comprenant les mêmes lignes assurant les mêmes connexions qu'un niveau conducteur classique. De préférence, on décale ainsi une ligne conductrice sur deux ce qui permet d'accroître la distance moyenne entre deux lignes pour le plus grand nombre de lignes possibles et de diminuer ainsi les capacités interlignes, par augmentation de la distance les séparant et ce, sans avoir à reprendre la conception et à modifier le dessin du circuit intégré.

Sur la figure 6, on voit la façon dont les vias sont connectés vers le haut ou vers le bas par rapport au niveau conducteur que l'on scinde en deux niveaux partiels. Le via 12 est destiné à assurer une connexion électrique entre un élément, non représenté, disposé à un niveau inférieur et une ligne 11b qui se trouve au niveau partiel supérieur n₂. On prévoit donc au niveau partiel inférieur n₁ un prolongement référencé 14 du via 12. Le prolongement 14 se situe au niveau partiel inférieur n₁ et peut présenter la même largeur que les lignes 11a, 11b. Un autre via 12 assure une connexion électrique entre un élément, non représenté, disposé à un niveau inférieur et une ligne 1 la qui se trouve au niveau partiel inférieur n₁.

De façon similaire, on voit que l'un des vias 13 est destiné à connecter une ligne 1 la du niveau partiel inférieur n₁ à un élément, non représenté, d'un niveau supérieur. Le via 13 est muni d'une prolongation 15 vers le bas, située au niveau partiel supérieur n₂ et assurant la connexion électrique entre le via 13 proprement dit et la ligne conductrice 1 la avec laquelle il doit être relié. A l'inverse, un via 13 peut être relié directement avec une ligne 11b tandis qu'un via 12 peut être relié directement avec une ligne 11a.

La présence des prolongations 14 et 15 des vias 12 et 13 dans les niveaux partiels inférieur n₁ et supérieur n₂ n'a qu'une faible influence sur les capacités interlignes dans la mesure où lesdites prolongations 14 et 15 sont ponctuelles, de même largeur d'une ligne et d'une longueur équivalente à la largeur d'un via ou à la largeur d'une ligne. Leur présence n'entraîne donc qu'un accroissement très faible des capacités interlignes en raison de cette faible surface présentée en regard des autres lignes. Cette augmentation reste négligeable par rapport à la diminution des capacités interlignes obtenues grâce à l'invention.

Sur les figures 7 à 10, sont illustrés les différents masques de résine servant à la fabrication d'un circuit intégré tel qu'illustré sur les figures 4 à 6. Sur la figure 7, le masque 16 comprend une zone évidée 17, obtenue par exemple par photogravure à l'emplacement correspondant au futur via 12. Ce masque 16 peut servir dans le cas d'un procédé double damascène avec couche d'arrêt à la gravure de la couche d'arrêt sur laquelle va être disposé le niveau partiel inférieur n₁. Dans le cas d'un procédé simple damascène, le masque 16 servira à la gravure dans la couche diélectrique disposée sous le niveau partiel inférieur n₁ du trou correspondant au futur via 12.

Le masque 18 illustré sur la figure 8 comprend des zones évidées 19 qui correspondent aux emplacements des futures lignes 1 la du niveau partiel inférieur n₁ et une zone évidée 17 disposée de façon identique à celle prévue dans le masque 16 et destinée à la fabrication du prolongement 14 du via 12 toujours au niveau n₁. Le masque 18 est utilisé pour la gravure d'une couche diélectrique disposée au niveau n₁ et qui assurera l'isolation entre les différentes lignes 11a et la prolongation 14.

Le masque 20 illustré sur la figure 9 comprend des zones évidées 21 aux emplacements correspondants aux futures lignes 11b du niveau partiel supérieur n₂ et une zone évidée 22 correspondant à l'emplacement du futur prolongement 15 du via 13 au niveau n₂. De la même façon que le masque 18, le masque 20 est utilisé pour la gravure d'une couche diélectrique du niveau n₂ qui assurera l'isolation électrique entre les différentes lignes 11b et la prolongation 15.

Le masque 23 illustré sur la figure 10 comprend une zone évidée 22 identique à celle du masque 20 et correspondant à l'emplacement d'un futur via 13 et une zone évidée 24 correspondant à l'emplacement d'un autre futur via 13. En procédé simple damascène, le masque 23 est utilisé pour la gravure de la couche diélectrique qui sépare le niveau partiel supérieur n₂ d'un autre niveau conducteur disposé au-dessus. Dans un procédé double damascène avec couche d'arrêt, le masque 10 est utilisé pour la gravure d'une couche d'arrêt, non représentée, disposée au-dessus de la couche diélectrique séparant le niveau partiel supérieur n₂ et le niveau conducteur disposé au-dessus.

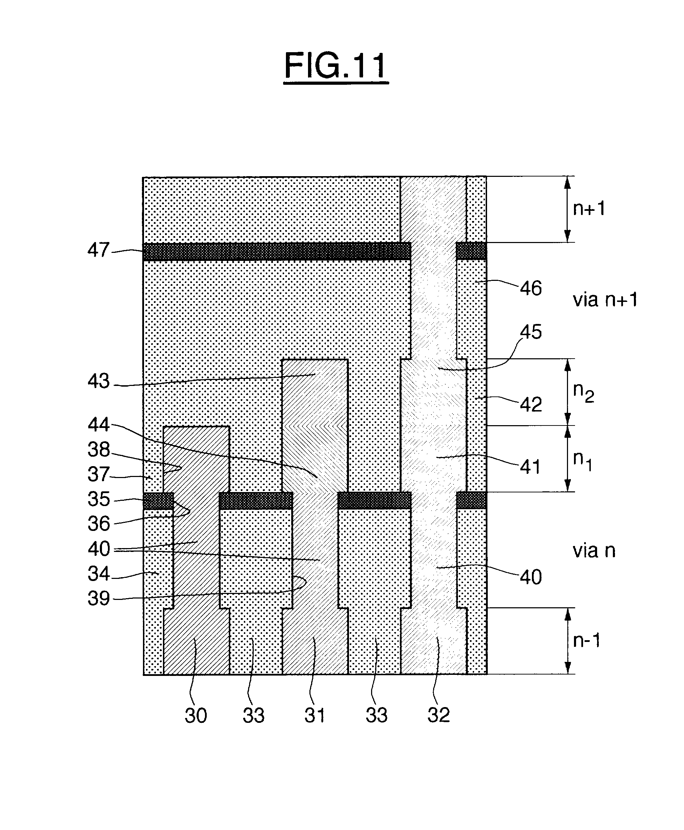

Sur la figure 11, est illustré un circuit intégré fabriqué selon un procédé double damascène avec couche d'arrêt. Sur le niveau conducteur n-1 qui comprend des lignes conductrices 30, 31 et 32 séparées par un matériau diélectrique 33, on dépose tout d'abord une couche diélectrique 34, par exemple en oxyde de silicium, puis une couche d'arrêt 35, de faible épaisseur, par exemple en nitrure de silicium. On procède ensuite à la gravure de la couche d'arrêt 35 au moyen d'un masque de résine, par exemple du type du masque 16 de la figure 7 pour obtenir trois trous 36 dans la couche d'arrêt 35. Cette étape de gravure est stoppée lorsqu'on atteint la couche diélectrique 34.

Puis on dépose une couche diélectrique 37, par exemple en oxyde de silicium. On procède à la gravure de la couche diélectrique 37 au moyen d'un masque de résine par exemple du type du masque 18 de la figure 8 de façon à définir des tranchées 38 dans la couche diélectrique 37 et des trous 39 dans la couche diélectrique 34 en se servant des trous 36 déjà formés dans la couche d'arrêt 35. On remplit ensuite de métal les trous 39 et les tranchées 38 et on forme ainsi les vias 40 et les lignes 41 du niveau partiel inférieur n₁.

Pour former le niveau partiel supérieur n₂ on dépose une couche diélectrique 42 que l'on grave au moyen d'un masque, par exemple du type du masque 20 de la figure 9 et on remplit de métal les tranchées ainsi formées pour obtenir des lignes 43. On remarque qu'au niveau n₁, le via 40 disposé au-dessus de la ligne 31 a été pourvu d'un prolongement 44 qui permet de le connecter à la ligne 43. Le prolongement 44 est disposé au niveau partiel inférieur n₁ et est formé en même temps que les lignes 41 dudit niveau n₁. De même, au niveau n₂ on prévoit une prolongation 45 permettant de connecter la ligne 41 disposée au-dessus de la ligne 32 avec un via de niveau n+1.

On dépose ensuite une couche diélectrique 46 puis une couche d'arrêt 47 et on peut répéter les étapes précédemment décrites pour former un niveau conducteur n+1 qui peut être de type classique sur un seul niveau ou de type conforme à l'invention sur deux niveaux partiels.

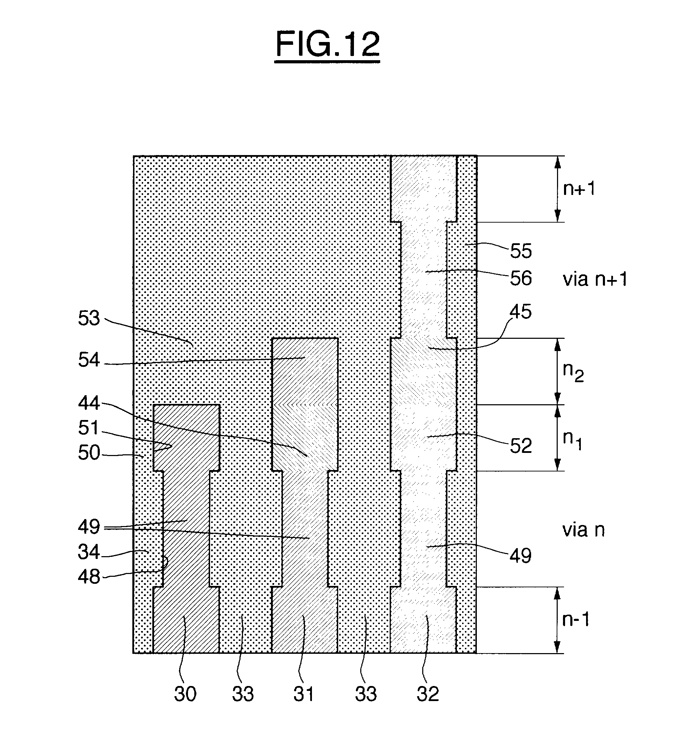

Sur la figure 12 est illustré un circuit intégré obtenu par un procédé simple damascène conforme à l'invention. Sur un niveau conducteur n-1 comprenant des lignes conductrices 30 à 32 séparées par un matériau diélectrique 33, on dépose une couche diélectrique 34 que l'on grave dans le but de former des trous 48 que l'on remplit ensuite de métal pour former des vias 49 de niveau n. Cette étape de gravure peut être effectuée au moyen d'un masque de résine, par exemple du type du masque 16 de la figure 7.

Puis on dépose une couche diélectrique 50 pour former le niveau partiel inférieur n₁. On procède à sa gravure au moyen d'un masque de résine, par exemple du type du masque 18 de la figure 8 ce qui permet d'obtenir des tranchées 51 que l'on remplit ensuite de métal pour former des lignes 52.

On dépose ensuite une couche diélectrique 53 que l'on grave au moyen d'un masque de résine, par exemple du type du masque 20 de la figure 9. On remplit ensuite de métal les tranchées ainsi obtenues pour former les lignes conductrices 54 du niveau conducteur n₂.

Comme pour le circuit intégré illustré sur la figure précédente, on prévoit des prolongations 44 et 45 là où cela s'avère nécessaire. On dépose ensuite une couche diélectrique 55 que l'on grave au moyen d'un masque de résine, par exemple du type du masque 23 de la figure 10 afin de former des vias 56 de niveau n+1. On peut ensuite répéter les étapes précédentes pour former le niveau conducteur n+1 qui peut être de type classique ou de type scindé en deux niveaux partiels décalés en hauteur, conformément à l'invention.

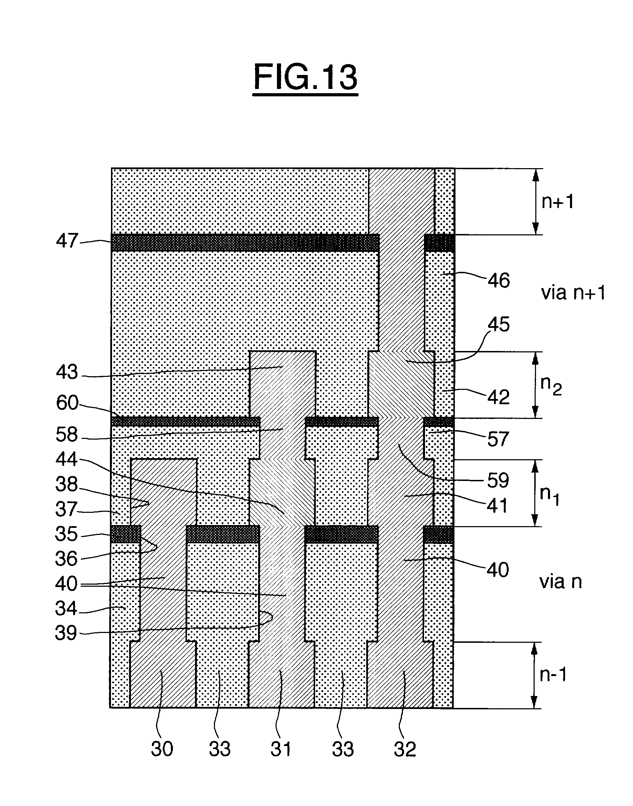

Sur la figure 13, est illustrée une variante du circuit intégré de la figure 11. Selon cette variante, les deux niveaux partiels inférieur n₁ et supérieur n₂ sont séparés par une couche supplémentaire 57 en matériau diélectrique et par une couche d'arrêt supplémentaire 60. La couche supplémentaire 57 est pourvue de vias supplémentaires 58 et 59 qui permettent d'assurer le contact électrique entre les niveaux partiels inférieur n₁ et supérieur n₂ Le via supplémentaire 58 est disposé entre la ligne conductrice 43 du niveau n₂ et le prolongement 44 au niveau n₁ du via 40 de niveau n. Le via supplémentaire 59 est disposé entre la ligne conductrice 41 du niveau n₁ et le prolongement 45 de niveau n₂ du via correspondant de niveau n+1.

Ces vias supplémentaires permettent d'assurer les connexions électriques nécessaires tout en permettant une augmentation de la distance entre les différentes lignes conductrices par exemple 41 et 43. Grâce à cela on obtient une diminution encore plus importante des capacités interlignes.

Dans les figures 11 à 13, le niveau n-1 a été considéré comme un niveau conducteur. Toutefois, il pourrait s'agir du substrat semi-conducteur tout en restant dans le cadre de l'invention.

Grâce à l'invention, on obtient une augmentation des performances en vitesse du circuit intégré grâce à la diminution de la constante de temps R x C où R est la résistance d'une ligne et C la capacité entre lignes et à la diminution de la diaphonie entre les lignes et ce grâce à la réduction des capacités interlignes. Cette réduction des capacités interlignes est obtenue indépendamment de la nature du diélectrique utilisé, indépendamment de la hauteur des lignes et sans augmentation du nombre de niveaux d'interconnexions au niveau de la conception du circuit. De plus, le fait de scinder un niveau conducteur donné en deux niveaux partiels ne nécessite pas de redessiner l'ensemble du circuit intrégré, ce qui aurait un coût extrêmement élevé mais nécessite une simple adaptation des schémas prééxistants et, ce, pour la définition des masques qui sont nécessaires.

Le circuit intégré conforme à l'invention peut donc être obtenu selon les procédés de fabrication damascènes quel que soit le type de procédé damascène utilisé. Le circuit intégré conforme à l'invention peut être aussi obtenu selon les procédés de fabrication conventionnels, c'est-à-dire par photolithogravure d'une couche métallique. Bien entendu, un circuit intégré peut être réalisé avec seulement un niveau conducteur conforme à l'invention ou plusieurs, jusqu'à la totalité de ces niveaux conducteurs. On peut ainsi modifier la fabrication d'un circuit intégré déjà en cours de production en réalisant, de façon conforme à l'invention, un niveau conducteur où se pose un problème particulier de capacités interlignes. Dans le cas d'un circuit fabriqué en double damascène avec couche supplémentaire diélectrique, on peut réaliser ladite couche supplémentaire diélectrique et le niveau n₂ selon un procédé double damascène d'où un gain de temps et une économie de fabrication. On peut aussi utiliser des diélectriques à faible permittivité et des métaux à faible résistivité pour les lignes et les vias.

## Revendications

1. Circuit intégré comprenant des pistes d'au moins un niveau de métallisation pourvu de couches diélectriques et des vias métallisés connectant des pistes de deux niveaux voisins et superposés, caractérisé par le fait qu'au moins une partie d'au moins un niveau de métallisation n est scindée en deux niveaux partiels décalés en hauteur, au moins un via (12) connectant une piste du niveau partiel supérieur et un élément situé sous la couche diélectrique de niveau n, ledit via traversant la couche diélectrique de niveau n et le matériau diélectrique séparant les pistes du niveau partiel inférieur, au moins un via (13) connectant une piste du niveau partiel inférieur et une piste d'un niveau de métallisation n+1, ledit via traversant la couche diélectrique de niveau n+1 et le matériau diélectrique séparant les pistes du niveau partiel supérieur, et au moins un via (12) connectant une piste du niveau partiel inférieur et un élément situé sous la couche diélectrique de niveau n.

2. Circuit selon la revendication 1, caractérisé par le fait que les pistes de la dite partie du niveau de métallisation sont réparties entre un niveau partiel supérieur n₂ et un niveau partiel inférieur n₁.

3. Circuit selon la revendication 1 ou 2, caractérisé par le fait que les pistes de la dite partie du niveau de métallisation sont prévues sans croisement entre elles.

4. Circuit selon l'une quelconque des revendications précédentes, caractérisé par le fait que les niveaux partiels supérieur et inférieur sont adjacents ou séparés par une couche de matériau diélectrique supplémentaire (57).

5. Circuit selon la revendication 4, caractérisé par le fait que la couche de matériau diélectrique supplémentaire est traversée par au moins un via connectant une piste du niveau partiel supérieur et un élément situé sous la couche diélectrique de niveau n et par au moins un via connectant une piste du niveau partiel inférieur et une piste d'un niveau de métallisation n+1.

6. Circuit selon la revendication 4 ou 5, caractérisé par le fait que les niveaux partiels supérieur et inférieur sont séparés par une couche de matériau diélectrique supplémentaire et par une couche d'arrêt (60) supplémentaire.

7. Procédé de fabrication d'un circuit intégré, dans lequel, sur une première couche diélectrique pourvue de vias, on dépose une deuxième couche diélectrique, on grave des tranchées dans la deuxième couche diélectrique, on réalise des pistes conductrices en remplissant de métal les dites tranchées, on dépose une troisième couche diélectrique, on grave des tranchées dans la troisième couche diélectrique, et on réalise des pistes conductrices en remplissant de métal les dites tranchées, pour obtenir au moins une partie du niveau de métallisation ainsi obtenu, scindée en deux niveaux partiels décalés en hauteur.

8. Procédé de fabrication d'un circuit intégré, dans lequel, sur une première couche conductrice, on dépose une première couche diélectrique puis une couche d'arrêt, on grave des trous dans la couche d'arrêt, on dépose une deuxième couche diélectrique, on grave des tranchées dans la deuxième couche diélectrique et des trous dans la première couche diélectrique aux emplacements correspondants à ceux des trous de la couche d'arrêt, on réalise des vias et des pistes conductrices en remplissant de métal les dits trous et les dites tranchées, on dépose une troisième couche diélectrique et une deuxième couche d'arrêt, on grave des trous dans la deuxième couche d'arrêt, on dépose une quatrième couche diélectrique, on grave des tranchées dans la quatrième couche diélectrique et des trous dans la troisième couche diélectrique aux emplacements correspondants aux trous de la deuxième couche d'arrêt, et on réalise des vias et des pistes conductrices en remplissant de métal les dits trous et les dites tranchées, pour obtenir au moins une partie du niveau de métallisation ainsi obtenu, scindée en deux niveaux partiels décalés en hauteur.

9. Procédé de fabrication d'un circuit intégré, dans lequel, sur une couche diélectrique pourvue de vias, on dépose puis on grave une première couche métallisée, on remplit de matériau diélectrique les espaces laissés libres par la gravure, on dépose puis on grave une deuxième couche métallisée, on remplit de matériau diélectrique les espaces laissés libres par la gravure, pour obtenir au moins une partie du niveau de métallisation ainsi obtenu, scindée en deux niveaux partiels décalés en hauteur.

10. Procédé selon l'une quelconque des revendications 7 à 9, caractérisé par le fait que les masques servant à la fabrication des lignes conductrices comportent des zones évidées correspondant à des prolongements servant à connecter une ligne d'un niveau partiel donné avec un via disposé à l'opposé dudit niveau partiel.
